# EUROPEAN PATENT APPLICATION

(11) **EP 2 357 578 A1**
(43) Date of publication of application: **17.08.2011**
(21) Application number: 10195341.2
(22) Date of filing: 16.12.2010
(51) Int. Cl.: G06F 17/50

(54) **Multiscale substructures in finite element analysis**

(30) Priority: 01.02.2010 US 300439 P; 21.06.2010 US 819475
(71) Applicant: Livermore Software Technology Corporation, Livermore CA 94551 (US)
(72) Inventor: Wainscott, Brian, Livermore, CA 94551-0712 (US); Hallquist, John O., Livermore, CA 94551-0712 (US)
(74) Representative: Becker Kurig Straus

(57) **Abstract**

Methods and systems for conducting a time-marching simulation of a product using a finite element analysis model including at least one multiscale substructure are disclosed. According to one aspect, a FEA model of a product is defined for a time-marching simulation. The FEA model comprises an overall structure, and at least one multiscale substructure. Each substructure corresponds to some of the master representative segments defined in the overall structure. Time-marching simulation of the product is conducted with first and second sets of timescale due to significantly different characteristic dimension of the FEA model. The first set is configured for the overall structure or master group, while the second set for the substructures or slave group. The first set is run at a time step significantly larger than the second set. Synchronization of the responses is at the end of each solution cycle corresponds to the first set of timescale.

## Description

### BACKGROUND OF THE INVENTION

The present invention generally relates to a method, system and software product used in computer-aided engineering analysis of a structure, more particularly to performing finite element analysis of an engineering structure including a multiscale susbstructures (e.g., spot welds). Multiscale is referred to as the substructure and overall engineering structure having a different scale finite element analysis model.

The finite element method (FEM) (sometimes referred to as finite element analysis (FEA)) is a numerical technique for finding approximate solutions of partial differential equations (PDE) as well as of integral equations. The solution approach is based either on eliminating the differential equation completely (steady state problems), or rendering the PDE into an approximating system of ordinary differential equations, which are then numerically integrated using standard techniques such as Euler's method, Runge-Kutta, etc.

FEA is becoming increasingly popular with automobile manufacturers for optimizing both the aerodynamic performance and structural integrity of vehicles. Similarly, aircraft manufacturers rely upon FEA to predict airplane performance long before the first prototype is built. Rational design of semiconductor electronic devices is possible with Finite Element Analysis of the electrodynamics, diffusion, and thermodynamics involved in this situation. FEA is utilized to characterize ocean currents and distribution of contaminants. FEA is being applied increasingly to analysis of the production and performance of such consumer goods as ovens, blenders, lighting facilities and many plastic products. In fact, FEA has been employed in as many diverse fields as can be brought to mind, including plastics mold design, modeling of nuclear reactors, analysis of the spot welding process, microwave antenna design, simulating of car crash and biomedical applications such as the design of prosthetic limbs. In short, FEA is utilized to expedite design, maximize productivity and efficiency, and optimize product performance in virtually every stratum of light and heavy industry. This often occurs long before the first prototype is ever developed.

One of the most challenging FEA tasks is to simulate an impact event such as car crash or metal forming. In a typical car, there are a larger number of spot welds connecting body parts to form the vehicle structure. For accurate simulation of the vehicle as a whole, those spot welds have to be modeled accurately. Spot welds are typically placed 2-3 centimeters apart, and each spot weld has a diameter between 4 to 9 millimeters. Traditionally, each spot weld has been modeled either with a very short beam element (e.g., length of 1-2 millimeters) in FEA or with a cluster of solid elements of roughly the same size as the surrounding elements (generally shell elements). As the modern computer improves, users (e.g., engineering, scientists, etc.) of the finite element analysis demand more detailed study of spot welds. That means a much finer model for the spot welds is required. Sometimes, the detailed spot weld model contains solid elements having characteristic dimension at least one order of magnitude less than that of the surrounding elements, for example, ten times less. When a substructure such as spot weld is so finely meshed, the time-marching simulation of the overall structure is affected.

Due to limitations of explicit solution scheme of the finite element method, a much smaller time-step is required to maintain a stable numerical solution for analyzing finely meshed spot welds. As a result, the time-marching simulation of the entire structure would take at least one order of magnitude longer time to run, which is not feasible in a production environment. Therefore, it would be desirable to have new improved method and system for performing a time-marching simulation of an engineering structure using finite element analysis, when a portion of the engineering structure is modeled with one or more much finely meshed substructures (e.g., spot welds).

### SUMMARY OF THE INVENTION

Methods and systems for conducting a time-marching simulation of a product using a finite element analysis model including at least one multiscale substructure are disclosed. According to one aspect of the present invention, a finite element analysis (FEA) model of a product (e.g., car, airplane, etc.) is defined for a time-marching simulation. The term "multiscale" is referred to as multiple time scales in terms of time-step sizes, for example, overall main structure may require a particular time-step size to maintain a stable solution in explicit FEM, while a substructure require another. The FEA model comprises an overall structure, and at least one multiscale substructure. Each of the substructures corresponds to some of the master representative segments defined in the overall structure. An example of using multiscale substructures is spot weld, which is used extensively in manufacturing of an automobile.

Characteristic dimension of the finite element analysis model for the overall structure is at least one order of magnitude (e.g., ten times) larger than that of the substructures. Each substructure can have different size FEA models. In other words, a first substructure and a second substructure can be modeled differently and, therefore requiring different time scales.

Time-marching simulation of the product is conducted with first and second sets of timescale. The first set is configured for the overall structure, or master group, while the second set for the substructures, or slave group. Due to characteristic dimension of the FEA model, the first set is run at a time step significantly larger than the second set. Synchronization of the responses of the two groups is performed at the end of each solution cycle corresponds to the first set (i.e., overall structure or master group) of timescale. The responses include, but are not limited to, deformations around the master representative segment.

Other objects, features, and advantages of the present invention will become apparent upon examining the following detailed description of an embodiment thereof, taken in conjunction with the attached drawings.

### BRIEF DESCRIPTION OF THE DRAWINGS

These and other features, aspects, and advantages of the present invention will be better understood with regard to the following description, appended claims, and accompanying drawings as follows:

FIG. 1A is a block diagram showing an exemplary computer, in which one embodiment of the present invention may be implemented;

FIG. 1B is a diagram illustrating an exemplary network environment that one embodiment of the present invention may be deployed;

FIG. 2A is a diagram showing an exemplary beam element;

FIG. 2B is a diagram showing an exemplary solid element;

FIG. 2C is a two-dimensional diagram showing several exemplary solid element clusters that can be used as a master representative segment in accordance with one embodiment of the present invention;

FIGS. 3A-3C are two-dimensional diagrams showing exemplary master representative segments configured for fastening two parts in different orientations, according to an embodiment of the present invention;

FIG. 4 is a two-dimensional diagram showing exemplary substructure definition used in a finite element analysis model in accordance with one embodiment of the present invention;

FIG. 5 is a flowchart illustrating an exemplary process of conducting a time-marching simulation of a product using a finite element analysis model including at least multiscale substructure in accordance with one embodiment of the present invention;

FIG. 6A is a diagram showing first and second exemplary sets of timescale configured for performing time-marching simulation of a product, according to an embodiment of the present invention; and

FIG. 6B is a diagram showing in real time timeline an exemplary FEA synchronization according to one embodiment of the present invention.

### DETAILED DESCRIPTIONS OF THE INVENTION

To facilitate the description of the present invention, it deems necessary to provide definitions for some terms that will be used throughout the disclosure herein. It should be noted that the definitions following are to facilitate the understanding and describe the present invention according to an embodiment. The definitions may appear to include some limitations with respect to the embodiment, the actual meaning of the terms has applicability well beyond such embodiment, which can be appreciated by those skilled in the art:

FEA stands for Finite Element Analysis.

Implicit FEA refers to K u = F, where K is the effective stiffness matrix, u is the unknown displacement array and F is the effective loads array. F is a right hand side loads array while K is a left hand side stiffness matrix. The solution is performed at the global level with a factorization of the effective stiffness matrix, which is function of the stiffness, mass and damping. One exemplary solution method is the Newmark integration scheme.

Explicit FEA refers to M a = F, where M is the diagonal mass array, a is the unknown nodal acceleration array and F is the effective loads array. The solution can be carried out at element level without factorization of a matrix. One exemplary solution method is called the central difference method.

Beam element refers to a one-dimensional finite element defined by two nodes.

Solid element refers to a three-dimensional finite element with volume. Typical solid elements may include, but not be limited to, tetrahedron, hexahedron, and the likes.

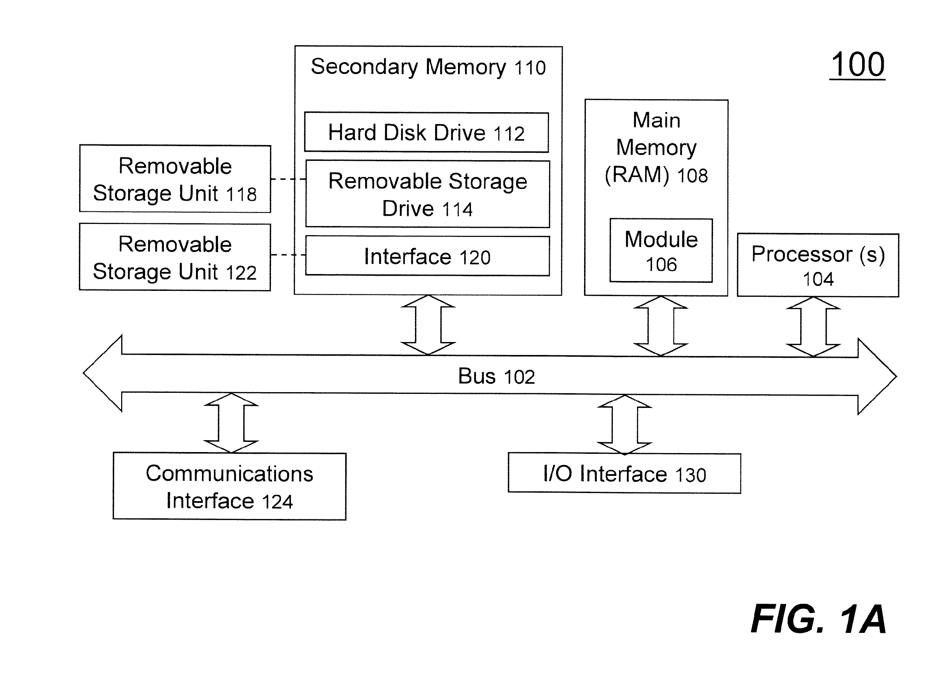

Embodiments of the present invention are discussed herein with reference to FIGS. 1A-6B. However, those skilled in the art will readily appreciate that the detailed description given herein with respect to these figures is for explanatory purposes as the invention extends beyond these limited embodiments.

Referring now to the drawings, in which like numerals refer to like parts throughout several views. The present invention may be implemented using hardware, software or a combination thereof and may be implemented in a computer system or other processing system. In fact, in one embodiment, the invention is directed towards one or more computer systems capable of carrying out the functionality described herein. An example of a computer system 100 is shown in FIG. 1A. The computer system 100 includes one or more processors, such as processor 122. The processor 122 is connected to a computer system internal communication bus 120. Various software embodiments are described in terms of this exemplary computer system. After reading this description, it will become apparent to a person skilled in the relevant art(s) how to implement the invention using other computer systems and/or computer architectures.

Computer system 100 also includes a main memory 108, preferably random access memory (RAM), and may also include a secondary memory 110. The secondary memory 110 may include, for example, one or more hard disk drives 112 and/or one or more removable storage drives 114, representing a floppy disk drive, a magnetic tape drive, an optical disk drive, etc. The removable storage drive 114 reads from and/or writes to a removable storage unit 118 in a well-known manner. Removable storage unit 118, represents a flash memory, floppy disk, magnetic tape, optical disk, etc. which is read by and written to by removable storage drive 114. As will be appreciated, the removable storage unit 118 includes a computer usable storage medium having stored therein computer software and/or data.

In alternative embodiments, secondary memory 110 may include other similar means for allowing computer programs or other instructions to be loaded into computer system 100. Such means may include, for example, a removable storage unit 122 and an interface 120. Examples of such may include a program cartridge and cartridge interface (such as that found in video game devices), a removable memory chip (such as Erasable Programmable Read-Only Memory (EPROM), Universal Serial Bus (USB) flash memory, or PROM) and associated socket, and other removable storage units 122 and interfaces 120 which allow software and data to be transferred from the removable storage unit 122 to computer system 100. In general, Computer system 100 is controlled and coordinated by operating system (OS) software, which performs tasks such as process scheduling, memory management, networking and I/O services.

There may also be a communications interface 124 connecting to the bus 102. Communications interface 124 allows software and data to be transferred between computer system 100 and external devices. Examples of communications interface 124 may include a modem, a network interface (such as an Ethernet card), a communications port, a PCMCIA slot and card, etc.

The computer 100 communicates with other computing devices over a data network based on a special set of rules (i.e., a protocol) to send data back and forth. One of the common protocols is TCP/IP (Transmission Control Protocol/Internet Protocol) commonly used in the Internet. In general, the communication interface 124 manages the assembling of a data file into smaller packets that are transmitted over the data network or reassembles received packets into the original data file. In addition, the communication interface 124 handles the address part of each packet so that it gets to the right destination or intercepts packets destined for the computer 100.

In this document, the terms "computer recordable storage medium", "computer recordable medium" and "computer readable medium" are used to generally refer to media such as removable storage drive 114, and/or a hard disk installed in hard disk drive 112. These computer program products are means for providing software to computer system 100. The invention is directed to such computer program products.

The computer system 100 may also include an I/O interface 130, which provides the computer system 100 to access monitor, keyboard, mouse, printer, scanner, plotter, and alike.

Computer programs (also called computer control logic) are stored as application modules 106 in main memory 108 and/or secondary memory 110. Computer programs may also be received via communications interface 124. Such computer programs, when executed, enable the computer system 100 to perform the features of the present invention as discussed herein. In particular, the computer programs, when executed, enable the processor 104 to perform features of the present invention. Accordingly, such computer programs represent controllers of the computer system 100.

In an embodiment where the invention is implemented using software, the software may be stored in a computer program product and loaded into computer system 100 using removable storage drive 114, hard drive 112, or communications interface 124. The application module 106, when executed by the processor 104, causes the processor 104 to perform the functions of the invention as described herein.

The main memory 108 may be loaded with one or more application modules 106 that can be executed by one or more processors 104 with or without a user input through the I/O interface 130 to achieve desired tasks. In operation, when at least one processor 104 executes one of the application modules 106, the results are computed and stored in the secondary memory 110 (i.e., hard disk drive 112). The status of the finite element model definition (e.g., the spot weld definitions, simulation results of the substructures at the end of desired solution cycles, etc.) is reported to the user via the I/O interface 130 either as a list or a graph.

In one embodiment, an application module 106 is configured to facilitate generation of solid elements representing substructures (e.g., spot welds). As an indication flag is detected, the application module 106 replaces the beam definition with one or more solid elements.

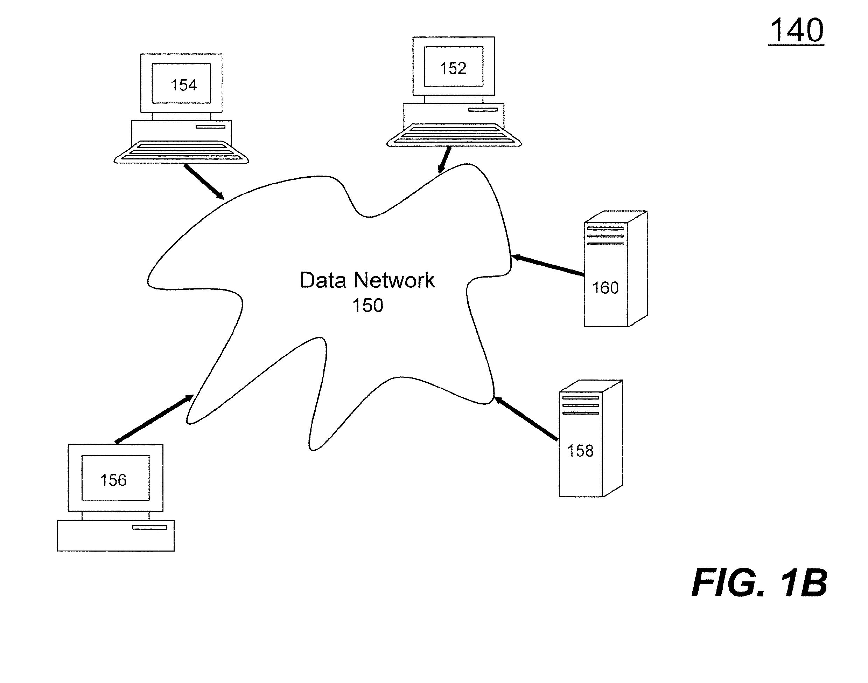

FIG. 1B depicts a networked computing environment 140, in which one embodiment of the present invention may be practiced. A plurality of network capable computing devices 152, 154, 156, 158 and 160 (e.g., the computer device 100 described in FIG. 1A) are coupled to a data network 150. These computing devices 152-160 can communicate with each other via the network 150. The data network 150 may include, but is not limited to, the Internet, an Intranet, local area network (LAN), wide area network (WAN), a wireless network or a data network comprises of public and private networks. In one embodiment, the application module (i.e., 106 in FIG. 1A) for an engineering analysis (e.g., finite element analysis) is configured and executed on a computing device 156. The user prepares the input file using a pre-processing software module also located on the device 156. And the analysis is performed and the output of the analysis is fed to a post-processing module to present the results either in numerical or graphical form. In another embodiment, the application module for an engineering analysis is configured and executed on the computing device 160. A user may prepare an input file describing physical structure (e.g., a vehicle, spot welds, etc.) on a personal workstation computing device 152. The input file is then sent to the computing device 160 via the network 150 to facilitate the computation of the engineering analysis. During the execution of the application module, the user may be able to monitor the progress of the analysis at another computing device 156. Finally after the analysis is completed, the user may examine the computed results by retrieving the stored result file from the computer 160 to any one of the computing devices 152, 154 or 156 for a post-processing, which in general includes a graphical representation of the analysis results.

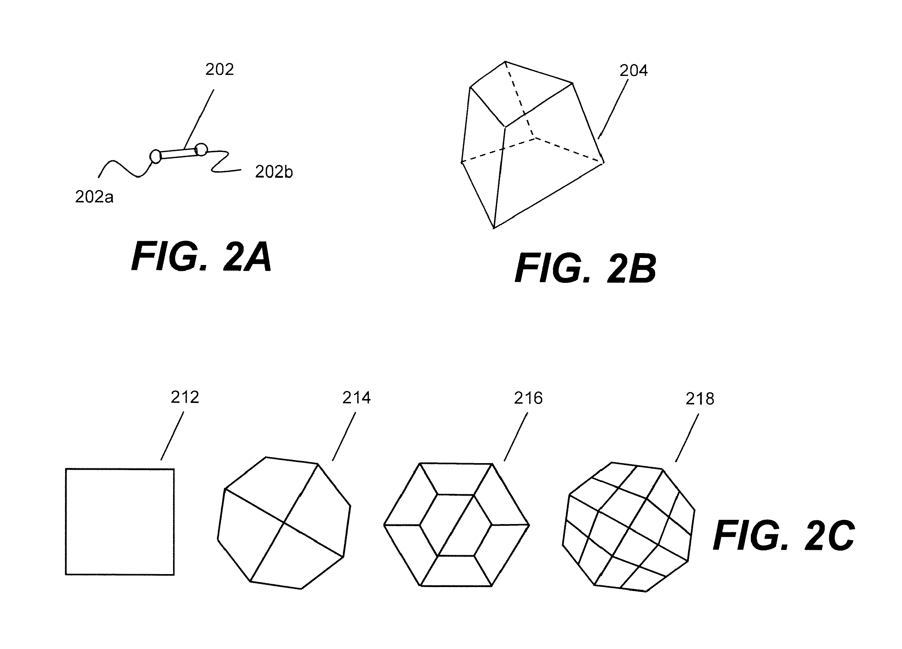

Manufacturing a complex structure such as an automobile, there are many structure members being connected to each other by some mechanical means, e.g., spot welds. In simulating large deformation (e.g., crash) of such complex structure, the overall FEA model requires not only to include the structure members but also to take into account the connectors, or spot welds. FIGS. 2A and 2B show an exemplary beam and an exemplary solid element that can be used to model spot welds in accordance with one embodiment of the present invention. Beam element 202 is a one-dimensional element defined by two end nodes 202A and 202B. Traditionally a very short (e.g., 1-2 mm length) beam element is used to model a spot weld connecting two metal parts in a structure (e.g., a vehicle). Alternatively, a spot weld may be modeled with one or more solid elements (e.g., hexahedron 204) in a cluster.

The solid elements representing the same spot weld are grouped together into a cluster, so that the resultant force and moment of the cluster (i.e., the spot weld) can be reported. Several exemplary solid element clusters are shown in FIG. 2C. Spot welds can be represented by one or more solid elements in a cluster. Exemplary hexahedron element clusters 212, 214. 216, and 218 depicted in FIG. 2C are for 1-, 4-, 8- and 16-elements, respectively. Although only four exemplary clusters are shown, the present invention does not limit to these four types. Other arrangements will be appreciated by those skilled in the art. Similarly, other types of the solid elements such as tetrahedron can be implemented in the present invention.

Beam and/or the solid elements representing spot welds are referred as master representative segments in the overall FEM model.

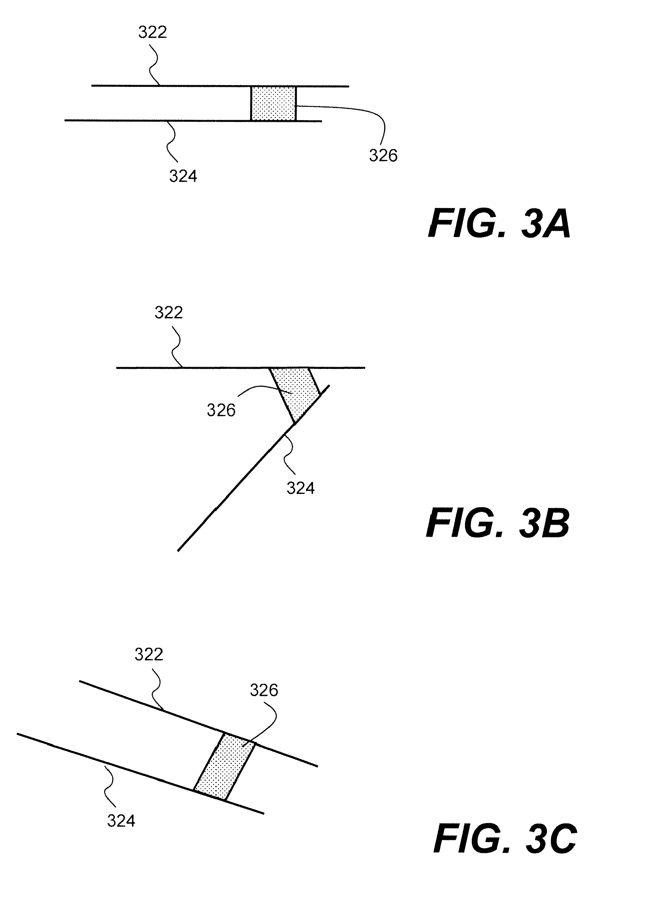

FIGS. 3A-3C are a two-dimensional diagrams showing exemplary FEA model of a master representative segment 326 configured for fastening two structural parts or members 322, 324 in different orientations, according to an embodiment of the present invention. In a time-marching FEA simulation, such as car crash simulation, the structure being analyzed may show deformations after each solution cycle. Accordingly, the connecting means (e.g., spot welds) connecting main structure members or structural parts, may also change their shapes. For example, in FIG. 3A, two structure members, 322 and 324, are connected by a spot weld 326. At the end of a particular solution cycle of the simulation, it deforms to a shape as shown in FIG. 3B, where the shape of the spot weld 326 is changed. At the end of another solution cycle, the structure is further deformed as shown in FIG. 3C, and again the spot weld 326 also further changes its shape.

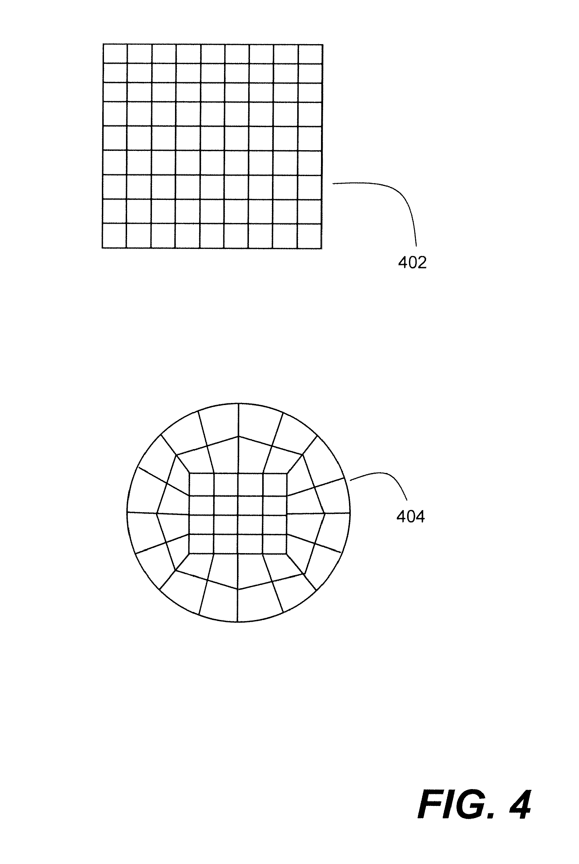

According to one aspect, each spot weld as a master representative segment 326 is further modeled with a finely meshed model of much smaller solid elements (e.g., more than 100 solid elements). Each of the finely meshed models is referred to as a substructure associated with respective master representative segment. The association between substructure and master representative segment can be one-to-one or one-to-many. In other words, each substructure is tied to some of the master representative segments defined in the overall FEM model. For example, several spot welds can be defined by one detailed substructure model. Plan views of two exemplary substructures are shown in FIG. 4. First substructure 402 comprises a 9x9 cubic element model, while second model 404 comprises rounded-shape boundary and fine meshes.

Depending on the location of interests and the detail of the simulation, one or more substructures may be constructed in a main structure under FEA analysis. Based on their characteristic dimensions, each of the substructure models may have different numbers of element and may be simulated in different size time-steps.

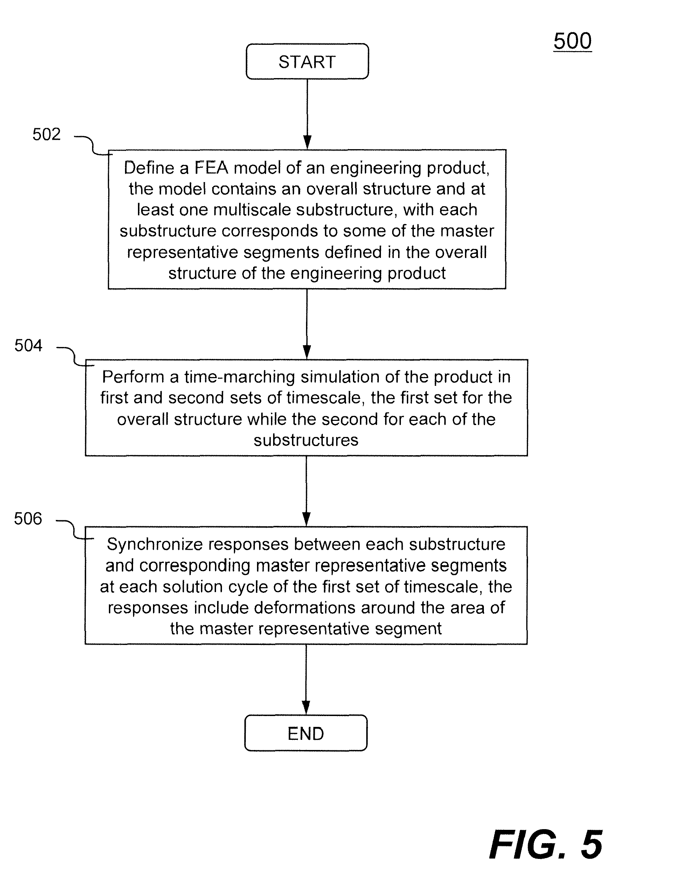

FIG. 5 is a flowchart illustrating an exemplary process 500 of conducting a time-marching simulation of a product using a finite element analysis model including at least multiscale substructure in accordance with one embodiment of the present invention. Process 500 is preferably implemented in software.

Process 500 starts at step 502 by defining a finite element analysis (FEA) model used in a time-marching simulation of a product. The FEA model comprises a master and a slave group. The master group includes the overall structure, while the slave group includes at least one multiscale substructure. Each substructure is integrated to the overall structure via corresponding master representative segment. The substructure is generally modeled with significantly finer mesh than the overall structure. As a result, characteristic dimension of the two FEA models (i.e., the master group and slave group) are significantly different. Usually the difference is at least one order of magnitude (e.g., ten times).

In order to maintain a stable solution for explicit solver of the FEA, first and second sets of timescale are required to perform the time-marching simulation. (step 504). The first set is configured for the master group, while the second set for the slave group. The time step size is controlled by the characteristic dimension of respective FEA models.

Finally at step 506, the simulated structural responses are synchronized at the end of each solution cycle of the first set of timescale. The simulated responses include deformations around the master representative segment.

Time-marching simulation can be performed on a multi-processor computer system. Parallel processing is achieved by dividing the master group and slave group into different domains independently. A root process of the master group and a root process of each of the substructures are the controller for synchronization operations.

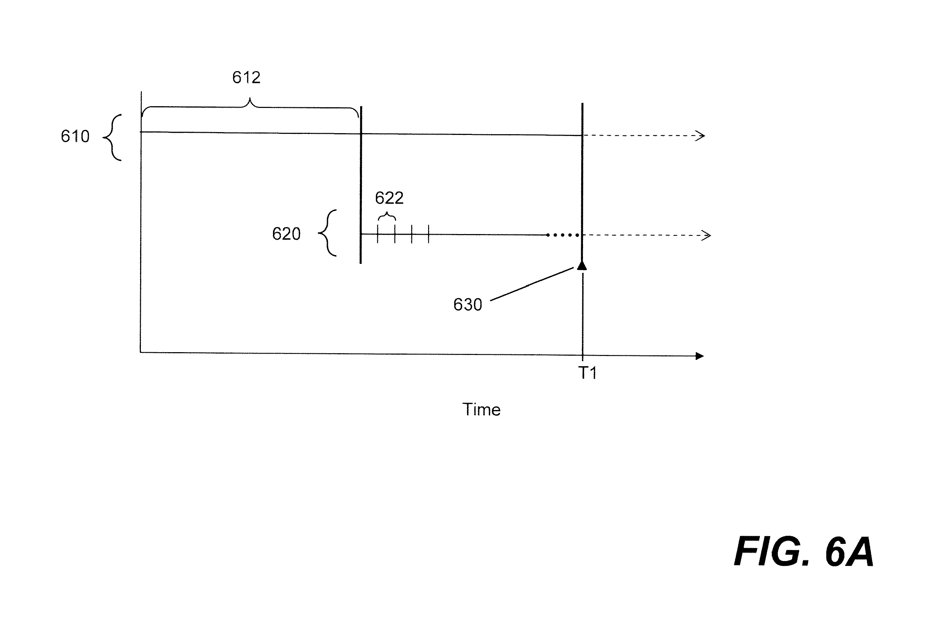

FIG. 6A is a diagram showing exemplary first and second sets of timescale configured for performing time-marching simulation of a product, according to an embodiment of the present invention. The first set of timescale 610 with time step 612 is used for solving the overall structure model. The second set of timescale 620 with a time step 622, which can be at least one order of magnitude smaller than that of the first set of timescale 610, is for solving the substructure models. In a time-marching simulation, the solution representing the overall structure response is obtained at the end of solution cycle of the first set of timescale 610. Then the responses of the substructures are obtained in the second set of timescale 620 using the just obtained results of the corresponding master representative segment as boundary condition.

To be able to couple the solutions of the substructure and the overall structure before the start of next time-marching simulation cycle, a solution synchronizing point 630 is set at T1, or at the end of each solution cycle of the first set of timescale, according to one embodiment of the present invention. This synchronization is carried out repeatedly at the end of each of the first set of timescale cycles as the time-marching simulation continues, for example, the next synchronization point is at T2 (not shown).

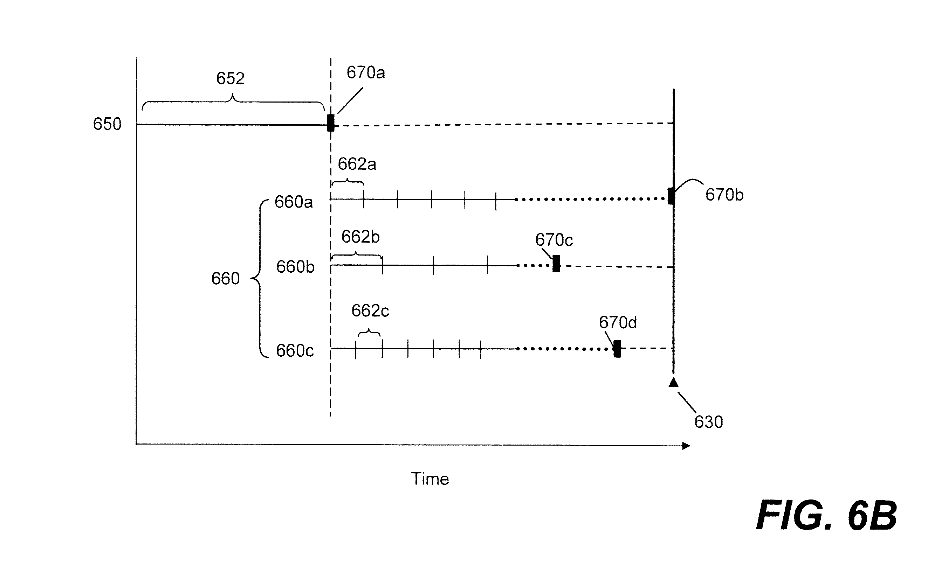

FIG. 6B is a diagram showing in a timeline an exemplary FEA synchronization of more than one substructure having different timescale according to one embodiment of the present invention. Simulation of an overall structure model is solved at a first set of timescale 650 with time step 652, with a second set of timescale 660 for three different substructures. The three substructures are modeled differently with different timescales, 660a, 660b and 660c and different time-steps 662a, 662b and 662c, respectively. The time-marching simulation starts at the same time for the three substructures right after the end 670a of each solution cycle of the overall FEA model. Depending upon the number of solid elements in each substructure and size of the element, each substructure may require different computation time to complete the simulation (e.g., shown three different end times 670b, 670c and 670d). A synchronization point 630 is now set at the instant when all the responses solutions are available after one time cycle, in this case, at 670b.

Although the present invention has been described with reference to specific embodiments thereof, these embodiments are merely illustrative, and not restrictive of, the present invention. Various modifications or changes to the specifically disclosed exemplary embodiments will be suggested to persons skilled in the art. For example, whereas illustration of substructure's finite element mesh is in two-dimension, the present invention is generally used in three-dimension. Additionally, whereas only two different configurations of substructure (FIG. 4) are shown and described, other equivalent shapes and sizes of model can be used instead. For example, a substructure can comprise 200x100 solid elements. There is no limitation as to what shape or size of the FEA model for the substructure. In summary, the scope of the invention should not be restricted to the specific exemplary embodiments disclosed herein, and all modifications that are readily suggested to those of ordinary skill in the art should be included within the spirit and purview of this application and scope of the appended claims.

## Claims

1. A method executed in a computer system for conducting a time-marching simulation of a product using a finite element analysis model including at least multiscale substructure, the method comprising:
defining, by an application module in a computer system, a finite element analysis (FEA) model representing a product, the FEA model containing an overall structure and at least one multiscale substructure, the overall structure includes one or more master representation segments each corresponds to one of the at least one multiscale substructure;
performing, by said application module, a time-marching simulation of the product with first and second sets of timescale, the first set is for obtaining the overall structure's structural responses, while the second set for said each of the at least one multiscale substructure's structural responses; and
synchronizing, by said application module, the overall structure's structural responses and the at least one multiscale substructure's structural responses at end of each solution cycle corresponding to the first set of timescale via the corresponding master representative segment, wherein the structural responses are saved into a file on a storage device and are graphically displayed to a monitor upon user's instructions.

2. The method of claim 1, wherein said each of the at least one multiscale substructures is modeled with a plurality of solid elements having a characteristic dimension significantly smaller than those elements used in modeling the overall structure.

3. The method of claim 1, wherein the second set of timescale is at least one order of magnitude, or ten times, smaller than the first set of timescale.

4. The method of claim 1, wherein the at least one multiscale substructure is modeled differently from one another.

5. The method of claim 4, wherein the second set of timescale for the at least one multiscale substructure is different from one another.

6. The method of claim 1, wherein the responses from said each of the at least one multiscale substructure inludes structural failures.

7. The method of claim 1, wherein the computer system comprises more than one processors configured for performing independent parallel executions of the finite element analysis for the overall structure and for said each of the at least one multiscale substructure.

8. The method of claim 1, wherein the one or more master representative segments are configured for coupling corresponding one of the at least one multiscale substructure to the overall structure.

9. The method of claim 1, wherein said each of the at least one multiscale substructure represents one or more spot welds on the product.

10. A computer readable medium containing instructions for controlling a computer system for conducting a time-marching simulation of a product using a finite element analysis model including at least one multiscale substructure by a method according to claim 1.

11. A system for conducting a time-marching simulation of a product using a finite element analysis model including at least one multiscale substructure, the system comprising:
a main memory for storing computer readable code for a finite element analysis application module;
at least one processor coupled to the main memory, said at least one processor executing the computer readable code in the main memory to cause the finite element analysis application module to perform operations by a method of::
defining a finite element analysis (FEA) model representing a product, the FEA model containing an overall structure and at least one multiscale substructure, the overall structure includes one or more master representation segments each corresponds to one of the at least one multiscale substructure;
performing a time-marching simulation of the product with first and second sets of timescale, the first set is for obtaining the overall structure's structural responses, while the second set for said each of the at least one multiscale substructure's structural responses; and
synchronizing the overall structure's structural responses and the at least one multiscale substructure's structural responses at end of each solution cycle corresponding to the first set of timescale via the corresponding master representative segment, wherein the structural responses are saved into a file on a storage device and are graphically displayed to a monitor upon user's instructions.
